# EUROPÄISCHE PATENTANMELDUNG

(11) **EP 3 301 716 A1**
(43) Veröffentlichungstag der Anmeldung: **04.04.2018**
(21) Anmeldenummer: 16191375.1
(22) Anmeldetag: 29.09.2016
(51) Int. Cl.: H01L 25/07, H01L 23/00

(54) **ANDRUCKVORRICHTUNG**

(71) Anmelder: Siemens Aktiengesellschaft, 80333 München (DE)
(72) Erfinder: Hensler, Alexander, 90766 Fürth (DE); Neugebauer, Stephan, 91058 Erlangen (DE); Pfefferlein, Stefan, 90562 Heroldsberg (DE)

(57) **Zusammenfassung**

Die Erfindung betrifft eine Andruckvorrichtung (1) zum Andrücken mindestens eines elektronischen Bauelements (3) an ein Kontaktelement (13), aufweisend einen Schaltungsträger (2), ein Biegeelement (4) mit mindestens einem Verbindungspunkt (14) und mindestens einem Andruckpunkt (6), mindestens ein Verbindungselement (5) und das Kontaktelement (13), wobei das Biegeelement (4) am Verbindungspunkt (14) mittels des Verbindungselements (5) mit dem Kontaktelement (13) mechanisch verbindbar ist, wobei das elektronische Bauelement (3) zwischen dem Schaltungsträger (2) und dem Kontaktelement (13) angeordnet ist, wobei das Biegeelement (4) durch das Verbindungselement (5) mechanisch beanspruchbar ist, wodurch eine Andruckkraft (AK) erzeugbar ist, wobei das Biegeelement (4) und der starre Schaltungsträger (2) in einem kraftwirkenden Kontakt stehen und die Andruckkraft (AK) über den Andruckpunkt (6) des Biegeelements (4) an den Schaltungsträger (2) übertragbar ist und wobei mittels der auf den Schaltungsträger (2) übertragbaren Andruckkraft (AK) das elektronische Bauelement (3) an das Kontaktelement (6) andrückbar ist.

## Beschreibung

Die Erfindung betrifft eine Andruckvorrichtung zum Andrücken mindestens eines elektronischen Bauelements an ein Kontaktelement.

Zur betriebsbedingten Entwärmung von elektronischen Schaltungen und meist auch zur Gewährleistung der mechanischen Stabilität der elektronischen Schaltung in Umrichtern der Industrie, werden oftmals deren elektronische Bauelemente mittelbar oder unmittelbar mit einer externen Peripherie in Kontakt gebracht. Die elektronischen Bauelemente schließen dabei insbesondere Leistungshalbleiter bzw. Leistungshalbleitermodule mit ein, welche bedingt durch deren Schaltverluste im Betriebsfall eine signifikante Wärmequelle darstellen, welche möglichst effizient im technischen wie auch betriebswirtschaftlichen Sinne entwärmt werden muss.

Die effiziente Entwärmung derartiger elektronischer Bauelemente ist jedoch eng damit verbunden, ob ein wirkungsvoller Wärmeübergang von dem elektronischen Bauelement als Wärmequelle hin zu einer Wärmesenke bzw. zu wärmeleitfähigen Komponenten herstellbar ist. Elektronische Bauelemente bzw. elektronische Module, welche beispielsweise eine Bodenplatte mit entsprechenden wärmeleitfähigen Eigenschaften aufweisen und gleichzeitig über die Bodenplatte konstruktionsbedingt eine Möglichkeit aufweisen, das elektronische Bauelement mit einem Entwärmungselement möglichst formschlüssig mittels beispielsweise Löten oder Schweißen zu verbinden, besitzen bzgl. deren Entwärmung einen Vorteil.

Kommen jedoch elektronische Bauelemente zum Einsatz, welche keine Bodenplatte aufweisen, ist es oftmals kaum möglich, den Wärmeübergangswiderstand zwischen den elektronischen Bauelementen und dem Entwärmungselement bezogen auf eine verfügbare Fläche unter Berücksichtigung der Überbrückung von Toleranzen und Deformationen der beteiligten Komponenten so zu gestalten, dass beispielsweise auf eine Überdimensionierung im Sinne der Wärmevermeidung aller an der Wärmeerzeugung und Entwärmung beteiligter Komponenten verzichtet werden kann. Die Nutzung beispielsweise von Schweiß- oder Lötverbindungen zur Sicherstellung eines akzeptablen Wärmeübergangswiderstands für die Anbindung der elektronischen Bauelementen oder Module ohne Bodenplatte an die entsprechenden Entwärmungselemente stellt in diesem Zusammenhang eine kaum praktikable Lösung dar.

Das Problem der mechanischen Ankontaktierung des elektronischen Bauelements ohne Bodenplatte an das Entwärmungselement unter Reduzierung des Wärmeübergangswiderstandes kann prinzipiell gelöst werden, indem auf das elektronische Bauelement eine Andruckkraft ausgeübt wird. Diese Kraftauswirkung kann zur Egalisierung insbesondere der beschriebenen Toleranzen und Deformationen der Oberflächen der beteiligten Komponenten führen, wobei sich dann auch der Wärmeübergangswiderstand reduzieren kann.

Aus der DE 10 2010 062 556 A1 ist eine Halbleiterschaltungsanordnung in Form eines Leistungshalbleitermoduls bekannt, welche Druckelemente mit einem Druckkörper aufweist. Der Druckkörper drückt dabei direkt auf ein Halbleiterbauelement. Die direkt auf das elektronische Bauelement einwirkende Kraft hat den Nachteil einer Beschädigung des Halbleiterbauelements insbesondere dann, wenn das Gehäuse des elektronischen Bauelements im Zuge einer Materialermüdung den Druck auf die innere elektrische Anordnung weitergibt.

Der Erfindung liegt die Aufgabe zugrunde, eine Vorrichtung zum Andrücken eines elektronischen Bauelements an ein Kontaktelement mit einer verbesserten Kraftwirkung auf das elektronische Bauelement gegenüber dem Stand der Technik bereitzustellen.

Der Erfindung liegt die Erkenntnis zugrunde, dass eine Andruckkraft, welche auf ein elektronisches Bauelement zur Kontaktierung mit einem Kontaktelement wirkt, gut dosierbar, zuverlässig und bauelementschonend sein muss. Weitere Anforderungen an eine entsprechende Vorrichtung zur Erzeugung der Andruckkraft sind ein platzsparender Aufbau, eine vielfältige Einsetzbarkeit und eine geringe Komplexität der Lösung.

Die Aufgabe wird durch eine Andruckvorrichtung mit den im Patentanspruch 1 angegebenen Merkmalen gelöst.

Erfindungsgemäß wird eine Andruckvorrichtung zum Andrücken mindestens eines elektronischen Bauelements an ein Kontaktelement vorgeschlagen, welche einen Schaltungsträger aufweist, ein Biegeelement mit mindestens einem Verbindungspunkt und mindestens einem Andruckpunkt aufweist, mindestens ein Verbindungselement und das Kontaktelement aufweist, wobei das Biegeelement am Verbindungspunkt mittels des Verbindungselements mit dem Kontaktelement mechanisch verbindbar ist, wobei das elektronische Bauelement zwischen dem Schaltungsträger und dem Kontaktelement angeordnet ist, wobei das Biegeelement durch das Verbindungselement mechanisch beanspruchbar ist, wodurch eine Andruckkraft erzeugbar ist, wobei das Biegeelement und der Schaltungsträger in einem kraftwirkenden Kontakt stehen und die Andruckkraft über den Andruckpunkt des Biegeelements an den Schaltungsträger übertragbar ist und wobei mittels der auf den Schaltungsträger übertragbaren Andruckkraft das elektronische Bauelement an das Kontaktelement andrückbar ist.

Ein Vorteil der erfindungsgemäßen Andruckvorrichtung zeigt sich in einer bauelementschonenden und mechanisch stabilen Einbettung des mit der Andruckkraft beaufschlagten elektronischen Bauelements zwischen Schaltungsträger und Kontaktelement sowie der damit einhergehenden großflächigen Kontaktierung des elektronischen Bauelements an das Kontaktelement.

Ein weiterer Vorteil der erfindungsgemäßen Andruckvorrichtung offenbart sich in der mittels des Biegeelements indirekt erzeugbaren Andruckkraft. Diese kann durch ein oder mehrere Verbindungselemente zentral oder dezentral an einem oder mehreren Verbindungspunkten durch die jeweilige mechanische Beanspruchung des Biegeelements erzeugt und über den jeweiligen Andruckpunkte des Biegeelements mittels des Schaltungsträgers an den oder die elektronischen Bauelemente verteilt. Daraus ergibt sich eine hohe Flexibilität bzgl. Erzeugung und Verteilung der Andruckkraft.

Die Andruckvorrichtung ist einerseits vorteilhaft geeignet, einen Wärmeübergangswiderstand zwischen dem elektronischen Bauelement und dem Kontaktelement möglichst gering zu halten, soweit das Kontaktelement zur Entwärmung vorgesehen ist. Andererseits ist die Andruckvorrichtung auch vorteilhaft geeignet, einen elektrischen Kontakt des elektronischen Bauelements zum Kontaktelement beispielsweise bzgl. Erzielung einer niederohmigen bzw. niederinduktiven elektrischen Verbindung zu verbessern, soweit das Kontaktelement für die elektrische Verbindung vorgesehen ist.

Vorteilhafte Ausgestaltungsformen der Andruckvorrichtung sind in den abhängigen Ansprüchen angegeben.

Bei einer ersten vorteilhaften Ausgestaltungsform der erfindungsgemäßen Andruckvorrichtung ist das Biegeelement mittels der mechanischen Beanspruchung plastisch verformbar oder elastisch verformbar.

Das Biegeelement ist vorzugsweise elastisch verformbar, was eine Anpassung der Andruckkraft vorteilhaft bei beispielsweise Service- und Wartungsintervallen ermöglicht. Auch vorwiegend elastisch formbares Material, wie z.B. Federstahl, ist jedoch schon aufgrund von Ermüdungsvorgängen plastischer Verformung ausgesetzt. So sollten Deformationen (z.B. durch thermische Ausdehnung), Entspannungen sowie Fertigungs- und Montagetoleranzen bei dem elastisch verformbaren Biegeelement ausgeglichen werden. Das Biegeelement kann für diese Fälle mit einer Durchbiegungsvorspannung beaufschlagt werden.

Das plastisch verformbare Biegeelement aus vorwiegend plastisch verformbarem Material, wie z.B. Kupfer oder Aluminium, eignet sich insbesondere bei Andruckvorrichtungen, wo die Andruckkraft für die elektronischen Bauelemente nur einmalig bestimmt und implementiert wird.

Bei einer weiteren vorteilhaften Ausgestaltungsform der erfindungsgemäßen Andruckvorrichtung weist das Biegeelement ein oder mehrere Biegesegmente gleicher oder unterschiedlicher Form und Größe auf und bilden die Biegesegmente eine Biegeelementstruktur des Biegeelements aus.

Die in Anzahl, Form und Größe variierbaren Biegesegmente, welche dem Biegeelement eine in vorteilhafter Weise anpassbare Biegeelementstruktur erlauben, können je nach Anzahl der elektronischen Bauelement und der daraus resultierenden, verteilt benötigten Andruckkraft anwendungsbezogen in der Andruckvorrichtung implementiert werden.

Beim Einsatz von mehreren Biegesegmenten des Biegeelements können die Biegesegmente unterschiedliche Biegesegmentlängen zwischen beispielsweise nur einem Verbindungspunkt für das eine Verbindungselement und mehreren Andruckpunkten aufweisen. Hierdurch kann eine resultierende Kraft aus einzelnen, verschiedenen Andruckkräften mit dem einen Verbindungspunkt für das eine Verbindungselement zur Deckung gebracht werden. Ferner ist es möglich, gleiche Andruckkräfte bei unterschiedlichen Biegesegmentlängen zu erhalten, indem die jeweiligen Biegesegmente mit variabler Biegesteifigkeit ausgelegt werden. Beispielsweise im Falle von zwei Andruckpunkten und einem Verbindungspunkt für das eine Verbindungselement müsste der eine Verbindungspunkt nicht mittig zwischen den Andruckpunkten angeordnet sein.

Bei einer weiteren vorteilhaften Ausgestaltungsform der erfindungsgemäßen Andruckvorrichtung sind die Biegesegmente des Biegeelements symmetrisch oder asymmetrisch zueinander angeordnet.

Diese vorteilhafte Ausgestaltungsform stärkt die Flexibilität der Verteilung der Andruckkraft an die elektronischen Bauelemente. Die symmetrische Anordnung der Biegesegmente erlaubt eine eher aufwandslose Implementierung für eine räumlich und wertmäßig gleiche Verteilung der Andruckkraft insbesondere bei Standardanwendungen. Die asymmetrische Anordnung der Biegesegmente eignet sich insbesondere zur Erstellung von komplexen Biegeelementstrukturen, welche sie für eine bedarfsgerechte Aufteilung der Andruckkraft bzgl. Wert und räumlicher Verteilung auf die elektrischen Bauelemente oft von spezifischen Anwendungen benötigt werden.

Bei einer weiteren vorteilhaften Ausgestaltungsform der erfindungsgemäßen Andruckvorrichtung sind die Biegesegmente mittels eines oder mehrerer Verbindungsstege verbunden.

Beim Einsatz von nur einem Biegesegment des Biegeelements wirken bevorzugt mindestens zwei Verbindungselemente an ihren jeweiligen Verbindungspunkten des Biegeelements bzgl. dessen mechanischer Beanspruchung, um eine Verdrehsicherung zu gewährleisten. Hierzu können auch beim Einsatz von mehreren Biegesegmenten des Biegeelements die Biegesegmente durch entsprechende Verbindungsstege miteinander verbunden werden. Um den einzelnen Biegesegmenten des Biegeelements ein weitgehend voneinander unabhängiges Durchbiegen zu ermöglichen, kann die Steifigkeit der Verbindungsstege dadurch gering gehalten werden, dass in die Verbindungsstege eine Materialschwächung eingebracht ist.

Bei einer weiteren vorteilhaften Ausgestaltungsform der erfindungsgemäßen Andruckvorrichtung ist die mechanische Beanspruchung des Biegeelements mittels des Verbindungselements einstellbar und ist dadurch die Andruckkraft wählbar.

Die Einstellung der mechanischen Beanspruchung des Biegeelements mittels ein oder mehrere Verbindungselemente ermöglicht in vorteilhafter Weise eine bedarfsgerechte Dimensionierung der Andruckkraft entweder für alle betroffenen elektronischen Bauelemente oder für einzelne ausgewählte elektronische Bauelemente.

Das Verbindungselement kann seine mechanische Verbindung zu dem Kontaktelement mittels einer Schraube, einem Einpresselement, einem Rastelement oder anderen geeigneten Verbindern herstellen und darüber die mechanische Beanspruchung des Biegeelements ausführen. Hat das Verbindungselement eine Einstellfunktion, kann ein Sicherungselement gegen eine ungewollte Verstellung des Verbindungselements vorgesehen werden.

Bei einer weiteren vorteilhaften Ausgestaltungsform der erfindungsgemäßen Andruckvorrichtung weist die Andruckvorrichtung mindestens ein Andruckübertragungselement auf, welches zwischen dem Biegeelement und dem Schaltungsträger angeordnet ist und dazu ausgebildet ist, die Andruckkraft vom Biegeelement an den Schaltungsträger zu übertragen.

Mittels des Andruckübertragungselements können konstruktiv bedingte räumliche Unterschiede vorteilhaft zwischen dem Biegeelement und dem Schaltungsträger ausgeglichen werden. Auch kann die Intensität der Andruckkraft, welche über den Schaltungsträger auf das elektronische Bauelement wirkt, mit dem Andruckübertragungselement reguliert werden.

Bei einer weiteren vorteilhaften Ausgestaltungsform der erfindungsgemäßen Andruckvorrichtung ist eine erste Verbindung des Andruckübertragungselements mit dem Biegeelement am Andruckpunkt des Biegeelements punktuell oder linienförmig ausgebildet.

Die Durchbiegung des Biegeelements bzw. des Biegesegments führt zu einer Winkeländerung zwischen dem Andruckübertragungselement und dem Biegeelement bzw. dem Biegesegment. Der Vorteil der punktuellen oder linienförmigen Ausbildung der ersten Verbindung am Andruckpunkt des Biegeelements in Form einer Gelenkfunktion liegt darin, dass hier die Winkeländerung im Gegensatz zu einer vergleichsweise flächigen Ausbildung der ersten Verbindung weniger Einfluss insbesondere auf eine Reduzierung der Wirksamkeit der Andruckkraft hat und auch eine mechanische Stabilität besser gewährleistet.

Bei einer weiteren vorteilhaften Ausgestaltungsform der erfindungsgemäßen Andruckvorrichtung sind das Andruckübertragungselement und das Biegeelement an dem Andruckpunkt des Biegeelements zueinander mechanisch fixierbar.

Das Andruckübertragungselement kann am Andruckpunkt des Biegeelements oder das Biegeelement mit dem Andruckpunkt am Andruckübertragungselement fixiert werden, um die Andruckvorrichtung einfacher vorkonfektionieren und montieren zu können. Das Andruckübertragungselement kann auch am Schaltungsträger fixiert werden. Diese Fixierungsmöglichkeiten sind als lösbare oder unlösbare mechanische Verbindungen ausführbar.

Bei einer weiteren vorteilhaften Ausgestaltungsform der erfindungsgemäßen Andruckvorrichtung weist die Andruckvorrichtung ein Ausgleichelement auf, welches zwischen dem Andruckübertragungselement und dem Schaltungsträger oder dem Biegeelement und dem Schaltungsträger angeordnet ist und dazu ausgebildet ist, Materialunebenheiten insbesondere des Schaltungsträgers auszugleichen und/oder elektrisch isolierend zu wirken.

Materialunebenheiten auf dem Schaltungsträger können z.B. durch Leiterzüge oder Flussmittelrückstände entstehen. Das Ausgleichelement kann auch in den Schaltungsträger integriert werden und zusätzlich eine elastische Decklage aufweisen.

Bei einer weiteren vorteilhaften Ausgestaltungsform der erfindungsgemäßen Andruckvorrichtung ist eine zweite Verbindung des Andruckübertragungselements mit dem Ausgleichelement oder eine dritte Verbindung des Biegeelements mit dem Schaltungsträger flächig ausgebildet.

Mittels der flächigen Ausbildung der zweiten Verbindung oder der dritten Verbindung des Andruckübertragungselements kann die Andruckkraft vergleichsweise großflächig auf den Schaltungsträger und über ihn auf das elektronische Bauelement übertragen werden.

Bei einer weiteren vorteilhaften Ausgestaltungsform der erfindungsgemäßen Andruckvorrichtung weist die Andruckvorrichtung ein Isolierelement auf, welches zwischen dem Verbindungselement und dem Schaltungsträger angeordnet ist und dazu ausgebildet ist, das Verbindungselement gegenüber dem Schaltungsträger elektrisch und/oder thermisch zu isolieren.

Bei einer weiteren vorteilhaften Ausgestaltungsform der erfindungsgemäßen Andruckvorrichtung ist das Isolierelement dazu vorgesehen, eine Biegeauslenkung des Biegeelements zu begrenzen, und weist die Biegeauslenkung des Biegeelements bei Anstehen der Andruckkraft eine Biegungselementvorspannung gegenüber dem Biegeelement ohne Anstehen der Andruckkraft auf.

Bei einer weiteren vorteilhaften Ausgestaltungsform der erfindungsgemäßen Andruckvorrichtung ist der Schaltungsträger als starrer Schaltungsträger ausgebildet und weist eine elektronische Schaltung auf, an der das elektronische Bauelement elektrisch angeordnet und mit mindestens einem elektronischen Schaltungselement elektrisch verbunden ist.

Insbesondere in den starren Schaltungsträger können sowohl das elektronische Bauelement wie auch die elektronischen Schaltungselemente der elektronischen Schaltung zumindest teilweise integriert, in einer Kavität versenkt oder in einen Lagenverbund des Schaltungsträgers eingepresst werden.

Bei einer weiteren vorteilhaften Ausgestaltungsform der erfindungsgemäßen Andruckvorrichtung ist das Kontaktelement ein Kühlelement oder ein Befestigungselement.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung der erfindungsgemäßen Andruckvorrichtung zum Andrücken mindestens eines elektronischen Bauelements an ein Kontaktelement,
- FIG 2: eine erste schematische Darstellung eines Biegeelements der erfindungsgemäßen Andruckvorrichtung nach FIG 1,
- FIG 3: eine zweite schematische Darstellung mit einem weiteren Biegeelement der erfindungsgemäßen Andruckvorrichtung,
- FIG 4: eine dritte schematische Darstellung mit einem weiteren Biegeelement der erfindungsgemäßen Andruckvorrichtung,
- FIG 5: eine vierte schematische Darstellung mit einem weiteren Biegeelement der erfindungsgemäßen Andruckvorrichtung,
- FIG 6: eine fünfte schematische Darstellung mit einem weiteren Biegeelement der erfindungsgemäßen Andruckvorrichtung und
- FIG 7: eine sechste schematische Darstellung mit einem weiteren Biegeelement der erfindungsgemäßen Andruckvorrichtung.

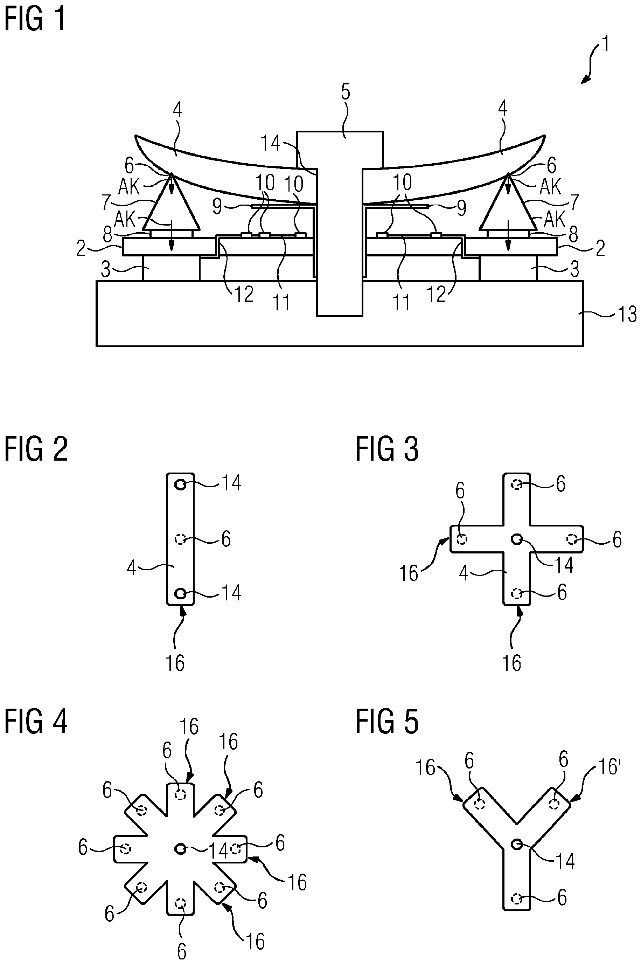

FIG 1 zeigt eine schematische Darstellung der erfindungsgemäßen Andruckvorrichtung 1 zum Andrücken mindestens eines elektronischen Bauelements 3 an ein Kontaktelement 13.

Auf einem Schaltungsträger 2 der Andruckvorrichtung 1 bilden elektronische Schaltungselemente 10 gemeinsam mit elektronischen Bauelementen 3 eine elektronische Schaltung 11. Die elektronischen Bauelement 3 können dabei als schaltbare Leistungshalbleiter ausgelegt sein, die elektronischen Schaltelemente 10 können beispielsweise Komponenten eines elektrischen Ansteuerkreises für die schaltbaren Leistungshalbleiter aufweisen. Ein derartiger Aufbau findet kann in Stromrichtern für elektrische Antriebssysteme seine Anwendung wieder.

Während die elektronischen Schaltungselemente 10 auf einer Oberseite des Schaltungsträgers 10 angeordnet sind, befinden sich die elektronischen Bauelemente 3 auf dessen Unterseite. Durchkontaktierungen 12 des Schaltungsträgers 2 stellen für die elektronische Schaltung 11 eine elektrische Verbindung zwischen den elektronischen Schaltungselementen 10 und den elektronischen Bauelementen 3 her.

Die elektronischen Bauelemente 3 erwärmen sich im Betriebsfall meist aufgrund von beispielsweise Schaltverlusten und müssen daher über das Kontaktelement 13, welches im Anwendungsbeispiel ein Kühlkörper sein kann, entwärmt werden. Um eine effiziente Entwärmung zu erzielen, soll zwischen den elektronischen Bauelementen 3 und dem Kontaktelement 13 ein möglichst geringer Wärmeübergangswiderstand auftreten, was mittels der Andruckvorrichtung 1 in vorteilhafter Weise realisiert werden kann.

Dazu wird ein Biegeelement 4 an einem Verbindungspunkt 14 des Biegeelements 4 mittels eines Verbindungselements 5 mechanisch beansprucht. Das Verbindungselement 5 kann beispielsweise eine Schraube sein, welche mit dem Kontaktelement 13 beispielsweise durch ein Gewinde mechanisch verbunden ist und eine einstellbare mechanische Beanspruchung des Biegeelements 4 erlaubt. Folge dieser mechanischen Beanspruchung des Biegeelements 4 ist eine Durchbiegung des Biegeelements 4, wobei eine Andruckkraft AK an Andruckpunkten 6 des Biegeelements 4 erzeugt wird. Begrenzt werden kann diese Durchbiegung des Biegeelements 4 mittels eines Isolierelements 9, welches eine thermisch und/oder elektrisch isolierende Funktion zur Isolierung des Verbindungselements 5 und/oder des Biegeelements 4 gegenüber dem Schaltungsträger 2 aufweist.

Das Biegeelement 4 steht über das Andruckübertragungselement 7 und das Ausgleichelement 8 in einem kraftschlüssigen Kontakt mit dem Schaltungsträger 2, welcher die Andruckkraft AK auf die elektronischen Bauelemente 3 überträgt. Die elektronischen Bauelemente 3 werden mittels der im Betrieb anstehenden Andruckkraft AK an das Kontaktelement 13 angedrückt, um den Wärmeübergangswiderstand gering zu halten.

Das Ausführungsbeispiel in FIG 1 zeigt demnach eine bauelementschonende und mechanisch stabile Einbettung der mit der Andruckkraft AK beaufschlagten elektronischen Bauelemente 3 zwischen Schaltungsträger 2 und Kontaktelement 13 sowie eine indirekte Erzeugung der Andruckkraft AK. Die elektronischen Bauelemente 3 müssen zur Erzielung einer Wirksamkeit der Andruckkraft AK nicht unbedingt in einer Linie mit den Andruckpunkten 6 des Biegeelements 4 liegen, an denen die Andruckkraft AK über die Andruckübertragungselement 7 an den Schaltungsträger 2 und schließlich an die elektronischen Bauelemente 3 übertagen wird.

Die FIG 2 visualisiert mittels einer ersten schematischen Darstellung das Biegeelement 4 der erfindungsgemäßen Andruckvorrichtung 1 nach FIG 1. Dieses Biegeelement 4 weist nur ein Biegesegment 16 auf, welches zumindest in Form und Größe beispielhaft auch als ein Basisbiegesegment für die Biegesegmente 16 der Figuren 3 bis 7 gesehen werden kann. Weiterhin weist das Biegeelement 4 zwei Verbindungspunkte 14 für zwei Verbindungselemente und einen Andruckpunkt 6 zur Übertragung einer Andruckkraft auf.

Die FIG 3 visualisiert mittels einer zweiten schematischen Darstellung ein weiteres Biegeelement 4 der erfindungsgemäßen Andruckvorrichtung 1. Dieses Biegeelement 4 bildet mit zwei Beigesegmenten 16 eine Biegesegmentstruktur in Form eines Kreuzes. Das Biegeelement 4 weist einen Verbindungspunkt 14 für ein Verbindungselement sowie vier Andruckpunkte 6 für die Andruckkraft AK auf.

Die FIG 4 visualisiert mittels einer dritten schematischen Darstellung ein weiteres Biegeelement 4 der erfindungsgemäßen Andruckvorrichtung 1. Dieses Biegeelement 4 bildet mit vier Beigesegmenten 16 eine Biegesegmentstruktur in Form eines Sterns. Das Biegeelement 4 weist einen Verbindungspunkt 14 für ein Verbindungselement sowie acht Andruckpunkte 6 für die Andruckkraft AK auf.

Die FIG 5 visualisiert mittels einer vierten schematischen Darstellung ein weiteres Biegeelement 4 der erfindungsgemäßen Andruckvorrichtung 1. Dieses Biegeelement 4 bildet mit einem Biegesegment 16 und einem Teilbiegesegment 16' eine Biegesegmentstruktur in Form eines Buchstaben Y. Das Biegeelement 4 weist einen Verbindungspunkt 14 für ein Verbindungselement sowie drei Andruckpunkte 6 für die Andruckkraft AK auf.

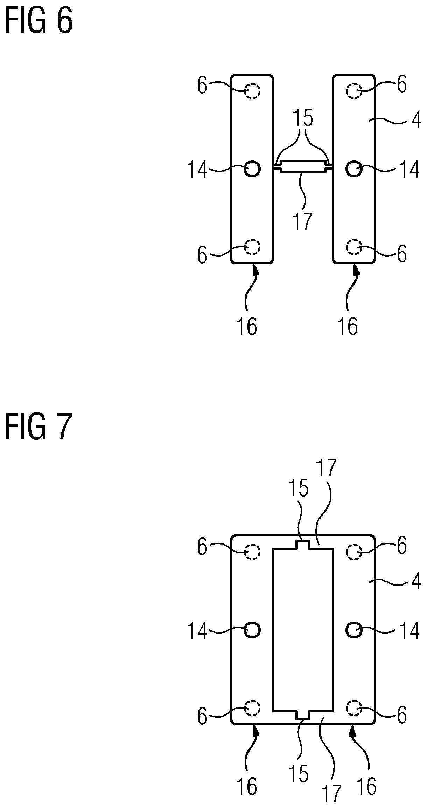

Die FIG 6 visualisiert mittels einer fünften schematischen Darstellung ein weiteres Biegeelement 4 der erfindungsgemäßen Andruckvorrichtung 1. Dieses Biegeelement 4 bildet mit zwei Biegesegmenten 16 und einem Verbindungssteg 17 zur Stabilisierung des Biegeelements 4 eine Biegesegmentstruktur in Form eines Buchstaben H. Das Biegeelement 4 weist zwei Verbindungspunkt 14 für zwei Verbindungselemente sowie vier Andruckpunkte 6 für die Andruckkraft auf. Der Verbindungssteg 17 ist mittels eingebrachter Materialschwächungen 15 flexibel gestaltet, um bei Wahrung der Stabilität des Biegeelements 4 die Durchbiegung der Biegesegmente 16 des Biegeelements 4 möglichst nicht zu behindern.

Die FIG 7 visualisiert mittels einer sechsten schematischen Darstellung ein weiteres Biegeelement 4 der erfindungsgemäßen Andruckvorrichtung 1. Dieses Biegeelement 4 bildet mit zwei Biegesegmenten 16 und zwei Verbindungsstegen 17 zur Stabilisierung des Biegeelements 4 eine Biegesegmentstruktur in Form eines Buchstaben O. Das Biegeelement 4 weist zwei Verbindungspunkt 14 für zwei Verbindungselemente sowie vier Andruckpunkte 6 für die Andruckkraft auf. Die Verbindungsstege 17 sind mittels eingebrachter Materialschwächungen 15 flexibel gestaltet, um bei Wahrung der Stabilität des Biegeelements 4 die Durchbiegung der Biegesegmente 16 des Biegeelements 4 möglichst nicht zu behindern.

## Patentansprüche

1. Andruckvorrichtung (1) zum Andrücken mindestens eines elektronischen Bauelements (3) an ein Kontaktelement (13), aufweisend
- einen Schaltungsträger (2),
- ein Biegeelement (4) mit mindestens einem Verbindungspunkt (14) und mindestens einem Andruckpunkt (6),
- mindestens ein Verbindungselement (5) und
- das Kontaktelement (13),
wobei
- das Biegeelement (4) am Verbindungspunkt (14) mittels des Verbindungselements (5) mit dem Kontaktelement (13) mechanisch verbindbar ist,
- das elektronische Bauelement (3) zwischen dem Schaltungsträger (2) und dem Kontaktelement (13) angeordnet ist,
- das Biegeelement (4) durch das Verbindungselement (5) mechanisch beanspruchbar ist, wodurch eine Andruckkraft (AK) erzeugbar ist,
- das Biegeelement (4) und der starre Schaltungsträger (2) in einem kraftwirkenden Kontakt stehen und die Andruckkraft (AK) über den Andruckpunkt (6) des Biegeelements (4) an den Schaltungsträger (2) übertragbar ist und
- mittels der auf den Schaltungsträger (2) übertragbaren Andruckkraft (AK) das elektronische Bauelement (3) an das Kontaktelement (6) andrückbar ist.

2. Andruckvorrichtung (1) nach Anspruch 1,
wobei das Biegeelement (4) mittels der mechanischen Beanspruchung plastisch verformbar ist oder elastisch verformbar ist.

3. Andruckvorrichtung (1) nach einem der vorhergehenden Ansprüche,
wobei das Biegeelement (4) ein oder mehrere Biegesegmente (16) gleicher oder unterschiedlicher Form und Größe aufweist und wobei die Biegesegmente (16) eine Biegeelementstruktur des Biegeelements (4) ausbilden.

4. Andruckvorrichtung (1) nach Anspruch 3,
wobei die Biegesegmente (16) des Biegeelements (4) symmetrisch oder asymmetrisch zueinander angeordnet sind.

5. Andruckvorrichtung (1) nach einem der Ansprüche 3 oder 4,
wobei die Biegesegmente (16) mittels eines oder mehrerer Verbindungsstege (17) verbunden sind.

6. Andruckvorrichtung (1) nach einem der vorhergehenden Ansprüche,
wobei die mechanische Beanspruchung des Biegeelements (4) mittels des Verbindungselements (5) einstellbar ist und dadurch die Andruckraft (AK) wählbar ist.

7. Andruckvorrichtung (1) nach einem der vorhergehenden Ansprüche,
aufweisend mindestens ein Andruckübertragungselement (7), welches zwischen dem Biegeelement (4) und dem Schaltungsträger (2) angeordnet ist und dazu ausgebildet ist, die Andruckkraft (AK) vom Biegeelement (4) an den Schaltungsträger (2) zu übertragen.

8. Andruckvorrichtung (1) nach Anspruch 7,
wobei eine erste Verbindung des Andruckübertragungselements (7) mit dem Biegeelement (4) am Andruckpunkt (6) des Biegeelements (4) punktuell oder linienförmig ausgebildet ist.

9. Andruckvorrichtung (1) nach einem der Ansprüche 7 oder 8,
wobei das Andruckübertragungselement (7) und das Biegeelement (4) an dem Andruckpunkt (6) des Biegeelements (4) zueinander mechanisch fixierbar sind.

10. Andruckvorrichtung (1) nach einem der Ansprüche 7 bis 9,
aufweisend ein Ausgleichelement (8), welches zwischen dem Andruckübertragungselement (7) und dem Schaltungsträger (2) oder dem Biegeelement (4) und dem Schaltungsträger (2) angeordnet ist und dazu ausgebildet ist, Materialunebenheiten insbesondere des Schaltungsträgers (2) auszugleichen und/oder elektrisch isolierend zu wirken.

11. Andruckvorrichtung (1) nach einem der Ansprüche 7 bis 10,
wobei eine zweite Verbindung des Andruckübertragungselements (7) mit dem Ausgleichelement (8) oder eine dritte Verbindung des Biegeelements (4) mit dem Ausgleichelement (8) flächig ausgebildet ist.

12. Andruckvorrichtung (1) nach einem der vorhergehenden Ansprüche,
aufweisend ein Isolierelement (9), welches zwischen dem Verbindungselement (5) und dem Schaltungsträger (2) angeordnet ist und dazu ausgebildet ist, das Verbindungselement (5) gegenüber dem Schaltungsträger (2) elektrisch und/oder thermisch zu isolieren.

13. Andruckvorrichtung (1) nach Anspruch 12,
wobei das Isolierelement (9) dazu vorgesehen ist, eine Biegeauslenkung des Biegeelements (4) zu begrenzen, und wobei die Biegeauslenkung des Biegeelements (4) bei Anstehen der Andruckkraft (AK) eine Biegungselementvorspannung gegenüber dem Biegeelement ohne Anstehen der Andruckkraft (AK) aufweist.

14. Andruckvorrichtung (1) nach einem der vorhergehenden Ansprüche,
wobei der Schaltungsträger (2) als starrer Schaltungsträger ausgebildet ist und eine elektronische Schaltung (11) aufweist, an der das elektronische Bauelement (3) elektrisch angeordnet und mit mindestens einem elektronischen Schaltungselement (10) elektrisch verbunden ist.

15. Andruckvorrichtung (1) nach einem der vorhergehenden Ansprüche,
wobei das Kontaktelement (13) ein Kühlelement oder ein Befestigungselement ist.
